# EUROPEAN PATENT APPLICATION

(11) **EP 4 442 855 A1**
(43) Date of publication of application: **09.10.2024**
(21) Application number: 23825052.6
(22) Date of filing: 08.09.2023
(51) Int. Cl.: C23C 14/56, C23C 14/34, C23C 14/02

(54) **COATING DEVICE AND COATING METHOD THEREOF**

(30) Priority: 23.02.2023 CN 202320348138 U; 28.07.2023 CN 202322022008 U; 23.02.2023 CN 202310189405
(71) Applicant: Zhejiang Shintown Industry Co., Ltd, Jinhua, Zhejiang 321399 (CN)
(72) Inventor: ZHANG, Mingwei, Jinhua, Zhejiang 321399 (CN); YAO, Yiqi, Jinhua, Zhejiang 321399 (CN); TANG, Jianzhong, Jinhua, Zhejiang 321399 (CN)
(74) Representative: Balder IP Law, S.L.
(86) International application number: PCT/CN2023/117711
(87) International publication number: WO 2024/174497

(57) **Abstract**

The application discloses a coating equipment and a coating method thereof. The coating equipment includes an etching chamber, the etching chamber is provided with a plasma source for processing the surface of the workpiece, an entrance to etching process with a gate valve and an exit of etching process with a transfer valve; a coating chamber provided with a sputtering cathode for sputtering the surface of the workpiece etched, an entrance to coating process with a transfer valve and an exit of coating process with a gate valve, the exit of etching process is in connection with the entrance to coating process; a transfer mechanism in the etching chamber and the coating chamber, the transfer mechanism is configured to transport the workpiece processed in the etching chamber to the coating chamber; a vacuum device in connection with the etching chamber and/or the coating chamber, the vacuum device is configured to form a vacuum in at least one of the etching chamber and the coating chamber; wherein the exit of etching process is in a sealed connection with the entrance to coating process, so that the etching chamber and the coating chamber are in a same vacuum state in a working state of the coating equipment. The coating equipment and coating method of this application have high coating production efficiency.

## Description

### CROSS-REFERENCE TO RELATED APPLICATION

This application is based on and requires Priority of patent application No.2023203481385 filed with the CNIPA on February 3, 2023, Chinese patent application No.2023101894053 filed with the CNIPA on February 3, 2023, and patent application No.2023220220085 filed with the CNIPA on July 28, 2023, the disclosure of each are incorporated herein by reference in their entirety.

### TECHNICAL FIELD

The present application relates to the technical field of mechanical processing, and in particular, to a coating equipment and a coating method thereof.

### BACKGROUND ART

To achieve the non-stick performance of existing cooking utensils, a layer of PTFE (polytetrafluoroethylene) is coated on the surface of the cooking utensil. The PTFE coating is nontoxic under normal conditions, but when the heating temperature of the coating reaches 260°C, it will begin to volatilize. When the temperature reaches 350°C, the PTFE coating will begin to decompose. Therefore, the use temperature of non-stick pans with PTFE coating should generally not exceed 250°C. However, the heating temperature of general cooking utensils such as woks often exceeds 260°C. So there are safety hazards. In addition, the coating is not wear-resistant and there is a risk that the coating will fall off, so it is easy to be accidentally eaten along with food, which affects the health.

There is currently a PVD process, by which a deposition layer can be formed on the surface of the product and has wear-resistant properties. However, the existing PVD process is configured to process wear-resistant coatings on the surface of products such as mobile phones, which is not suitable for processing non-stick and wear-resistant coatings on the surface of cooking utensils. In addition, the existing PVD equipment and processes are complex, and the processing time is long, by which the processing cycle of a single product is about 3 hours, which have high processing cost and cannot meet the needs of mass production.

### SUMMARY

In order to solve the above technical problems, this application provides a coating equipment and a coating method thereof, which can improve the production efficiency of coating processing, reduce processing costs, and thus meet the needs of mass production.

As a first aspect, the application provides a coating equipment, including:

an etching chamber configured to improve adhesion performance of a surface of a workpiece, the etching chamber is provided with a plasma source for processing the surface of the workpiece, an entrance to etching process with a gate valve and an exit of etching process with a transfer valve;

a coating chamber configured to form a deposition layer on the surface of the workpiece, the coating chamber is provided with a sputtering cathode for sputtering the surface of the workpiece etched, an entrance to coating process with a transfer valve and an exit of coating process with a gate valve, the exit of etching process is in connection with the entrance to coating process;

a transfer mechanism at least partially disposed in the etching chamber and/or the coating chamber, the transfer mechanism is configured to transport the workpiece processed in the etching chamber to the coating chamber;

a vacuum device in connection with the etching chamber and/or the coating chamber, the vacuum device is configured to form a vacuum in at least one of the etching chamber and the coating chamber;

wherein the exit of etching process is in a sealed connection with the entrance to coating process, so that the etching chamber and the coating chamber are in a same vacuum state in a working state of the coating equipment.

According to the above technical solution, the etching chamber and the coating chamber perform the processing in separate zones, and the etching chamber and the coating chamber are in the same vacuum state. When processing the surface of the workpiece, the surface of the workpiece is etched in the etching chamber at first, so that the adhesion performance of the surface of the workpiece is improved. The workpiece etched enters the coating chamber. In the coating chamber, a physical vapor deposition is performed on the surface of the workpiece to form a coating layer that is both non-stick and wear-resistant. The transfer mechanism can transport workpieces back and forth between the etching chamber and the coating chamber, and can realize automated processing and transportation in a vacuum state. Through the improvement of the design of coating equipment, the etching chamber and coating chamber can not only work in separate zones, but also realize continuous transportation of workpieces through the transfer mechanism. In the entire procedure from the etching processing to the coating processing, the production efficiency will not be affected due to frequent vacuumization and vacuum breaking. A seamless and continuous automated processing can be achieved. The whole process does not require human intervention and the production efficiency is high.

The vacuum device can form a vacuum state in at least one of the etching chamber and the coating chamber, and the both of them can achieve the same vacuum state through a sealed connection. When the workpiece enters the etching chamber from the external atmospheric pressure environment for etching, it is necessary to braking vacuum of the etching chamber, because the workpiece can only enter when the etching chamber is at the same pressure as the outside atmospheric pressure. The etching chamber and the coating chamber are connected through a gate valve, so that the both are spatially separated and sealed to maintain the vacuum state of the coating chamber when vacuum of the etching chamber is broken. The workpiece can firstly enter the etching chamber, then the gate valve at the input of the etching chamber can be closed. Vacuum is evacuated through a vacuum device connected to the etching chamber and/or the coating chamber, and the gate valve of the etching chamber and the coating chamber is opened, so that the etching chamber is in communication with the coating chamber to achieve the same vacuum state. Because there is a gate valve isolation between the etching chamber and the coating chamber, and they can separately connected with the vacuum device, the time for the etching chamber to re-reach the vacuum state after the workpiece enters is short, which reduces the switching time.

If the surface of cooking utensil products is coated, the processing time of a single product can be shortened to 5-8 minutes, which improves the production efficiency and greatly reduces the processing cost of a single product, thereby meeting the needs of mass production.

In combination with the first aspect, furthermore, the etching chamber is provided with an input zone with a heating device and at least one etching zone with a plasma source connected with each other, the input zone and the etching zone are connected with each other through a transfer valve, the vacuum device is in connection with the etching zone to form a vacuum in the etching zone, the entrance to etching process is disposed in the input zone, and a spatial volume of the input zone is smaller than a spatial volume of the etching zone.

According to the above technical solution, the etching zone in the etching chamber is in a vacuum state. When the workpiece enters the etching chamber from the external atmospheric pressure environment for etching, it is necessary to break vacuum of the etching chamber, because the workpiece can only enter when the etching chamber is at the same pressure as the outside atmospheric pressure. The etching chamber is divided into an input zone and an etching zone. The input zone and the etching zone are connected through a transfer valve, such that the both are spatially separated and sealed. The workpiece can firstly enter the input zone, which can be in communication with the etching zone to achieve a vacuum state after the transfer valve is opened. The transfer mechanism transports the workpiece from the input zone to the etching zone for processing. The input zone is configured for the entry of workpiece, which possesses a small spatial volume, so the time to achieve the vacuum state by communicating with the etching zone is short, which reduces the switching time. The heating device can perform preliminary heating treatment on the workpiece, which facilitates the etching of the surface of the workpiece by the plasma source.

In combination with the first aspect, furthermore, the input zone is also connected to the vacuum device, after the input zone is in a same vacuum state as the etching zone through the vacuum device, the transfer valve between the etching zone and the input zone is opened, and the transfer mechanism transports the workpiece from the input zone to the etching zone.

According to the above technical solution, the input zone is provided with a vacuum device. When the previous workpiece is processed in the etching zone, the vacuum device vacuumizes the input zone, so that the input zone and the etching zone achieve the same vacuum state, and the workpiece can be heated at the same time. After the previous workpiece is processed in the etching zone, the workpiece in the input zone can be transported to the etching zone for processing through the transfer mechanism. Therefore a continuous and uninterrupted processing of the workpiece is realized, which reduces the switching time and improves the production efficiency.

In combination with the first aspect, furthermore, the etching zone comprises a heating zone, a processing zone and a waiting zone which are connected in sequence, there are transfer valves between the heating zone, the processing zone and the waiting zone, so that the heating zone, the processing zone and the waiting zone can respectively form a relatively closed space, the heating zone and the input zone is connected through the transfer valve, the heating zone is provided with a heating device, the plasma source is disposed in the processing zone, and the waiting zone is in connection with the coating chamber.

According to the above technical solution, the workpiece transported from the input zone can be heated in the heating zone, to reach the temperature required for etching, so that the workpiece can enter the processing zone for etching. The transfer valves are disposed between the heating zone, the processing zone and the waiting zone to form a relatively closed space between them, so that the heating zone, the processing zone and the waiting zone can be kept in the same vacuum state and the influence of different space temperature factors to ensure the quality of etching processing can be reduced. The waiting zone and the processing zone are separated by a transfer valve, which can reduce the environmental interference between the etching chamber and the coating chamber when the etched workpiece is transported to the coating chamber, thereby improving the processing quality of the etching and coating of workpieces.

In combination with the first aspect, furthermore, the coating chamber comprises a buffer zone, a sputtering zone, a cooling zone and an output zone which are connected in sequence, there is a transfer valve between each zone, so that the buffer zone, the sputtering zone, the cooling zone and the output zone can respectively form a relatively closed space, the exit of coating process is disposed in the output zone; the vacuum device is at least in connection with one of the buffer zone, the sputtering zone and the cooling zone to form a vacuum in the buffer zone, the sputtering zone, and the cooling zone, respectively.

According to the above technical solution, the coating chamber is divided into a buffer zone, a sputtering zone, a cooling zone and an output zone, and a transfer valve is disposed between each zone, so that the buffer zone, the sputtering zone, the cooling zone and the output zone form a relatively closed space, which can reduce the environmental interference between different zones and improve the processing quality of the coating. With the vacuum device can the vacuum state of the buffer zone, the sputtering zone and the cooling zone be further ensured, which ensures the environmental conditions during the coating processing, thereby improving the consistency of the coating quality.

In combination with the first aspect, furthermore, the buffer zone is in connection with the etching zone to park the workpiece transferred from the etching zone, the sputtering cathode is disposed in the sputtering zone, and the cooling zone is provided with a cooling device for cooling the workpiece coated in the sputtering zone.

According to the above technical solution, with the buffer zone the environmental interference between the coating chamber and the etching chamber can be reduced. The workpiece processed in the etching chamber undergoes environmental transition through the buffer zone, which facilitates the improvement of the quality of subsequent coating processing and shortening of the waiting time. The coated workpieces is cooled in the cooling zone, which facilitates the transportation and packaging of the workpieces and continuous processing.

In combination with the first aspect, furthermore, the output zone is also connected to the vacuum device, after the output zone is in a same vacuum state as the cooling zone through the vacuum device, the transfer valve between the cooling zone and the output zone is opened, and the transfer mechanism transports the workpiece from the cooling zone to the output zone.

According to the above technical solution, the output zone is provided with a vacuum device, which can achieve the same functional effect as in the input zone and an uninterrupted transportation of workpieces between the vacuum processing environment and the atmospheric pressure environment. After the output zone achieves the same vacuum state as the cooling zone with the vacuum device, the transfer mechanism transports the workpiece from the cooling zone to the output zone, then the transfer valve between the cooling zone and the output zone is closed, vacuum of the output zone is broken, and the workpiece is transferred to the subsequent detection and packaging process. After the workpiece is taken out from the output zone, the output zone is vacuumized, so that the processed workpiece can be transported continuously and uninterruptedly, which improves the turnover efficiency. The isolation between the processing zone and the external environment can be enhanced with the output zone, which reduces the environmental pollution.

In combination with the first aspect, furthermore, the entrance to etching process is connected with a first rotary transport mechanism, the exit of coating process is connected with a second rotary transport mechanism, an end of the first rotary transport mechanism facing away from the entrance to etching process is in connection with an end of the second rotary transport mechanism facing away from the exit of coating process through the conveying mechanism, so that an endless production mode is formed in the coating equipment.

According to the above technical solution, through the first rotary transport mechanism and the second rotary transport mechanism, a cycle production mode can be formed in the coating equipment, which improves the production efficiency and reduces the processing cost, thereby facilitating the Mass production.

In combination with the first aspect, furthermore, the conveying mechanism is provided with an occupancy detection device, a handling mechanism and a heating channel in sequence in a direction from the second rotary transport mechanism towards the first rotary transport mechanism.

According to the above technical solution, the occupancy detection device can automatically perform an occupancy detection on the processed workpiece transferred from the second rotary transport mechanism. The handling mechanism carry out an unloading and placing work on the second rotary transport mechanism when a workpiece is detected thereon. The handling mechanism places the workpiece to be processed on the second rotary transport mechanism when no workpieces is detected thereon. The workpiece to be processed on the second rotary transport mechanism undergoes the first step of heating in the heating channel, and the heated workpiece is transported to the etching chamber through the first rotary transport mechanism. By the occupancy detection device, the handling mechanism and the heating channel, the automatic loading and unloading and preheating of workpieces can be realized, in addition, closed-loop automatic production can be realized in the atmospheric and vacuum environments, which improves the production efficiency.

In combination with the first aspect, furthermore, a coating zone is provided in the coating chamber, a quantity of the coating chamber is a, a quantity of the coating zone is a*N, wherein a is a natural number from 2 to 4, and N is a natural number from 2 to 4.

According to the above technical solution, at least two coating chambers are provided, and each coating chamber can be provided with a target material for sputtering coating. The quantity of the coating zones is determined to be 2-4 times of the quantity of the coating chambers, which can achieve a good coating processing and economical and a reasonable length of the production line and facilitate a standardized manufacturing of the coating chambers.

In combination with the first aspect, in a further solution, the a is 2 or 3.

According to the above technical solution, the coating chamber can meet the needs of conventional coating production. Generally, when a product is coated with various materials, two target materials are most commonly used, which can meet product performance requirements and also be the most economical. When the quantity of coating chambers is set to two or three, only one coating chamber is used for coating, and the other coating chambers are used as cooling chambers. The production line can also meet the requirements of the production of a product with one target material to be sputtered and coated. The switch of the production line is more flexible, so that the coating requirements for realizing the performance of various products can be met without changing the production line.

In combination with the first aspect, furthermore, the N is 2 or 3.

According to the above technical solution, only one coating zone of the coating chamber for processing is generally needed. However, during the developing, adjusting and testing process of the equipment, it was found that if the quantity of the coating zones is set to 2 or 3, the coating quality will be more stable and the length of the production line will be the most reasonable, the processing cost and defective rate are relatively low.

In combination with the first aspect, furthermore, there is a transfer valve between every two of the coating chambers.

According to the above technical solution, there is a transfer valve between every two coating chambers, so that they can form a relatively closed space with each other. That is, different coating chambers can be kept in a common vacuum state when the transfer valve is opened. In addition, when the transfer valve is closed, the influence of factors such as target materials and temperatures in different coating chambers can be reduced to ensure the quality of coating processing. With the transfer valve the coated workpiece in the previous coating chamber can be transported to the next coating chamber, so that the environmental interference between different coating chambers can be reduced, thereby the processing quality of the coating of workpieces is improved.

In combination with the first aspect, furthermore, the coating chamber comprises at least two coating zones, namely a buffer zone and a sputtering zone which are connected in sequence, and the buffer zone is in connection with an inlet of the coating chamber.

According to the above technical solution, the coating chamber is divided into a buffer zone and a sputtering zone, and a transfer valve is disposed between each zone, so that the buffer zone and the sputtering zone form a relatively closed space, which can reduce the environmental interference between different zones, thereby improving the processing quality. The buffer zone is in connection with the input of the coating chamber. When the workpiece from the previous process enters the coating chamber, it can transition in the buffer zone to complete the buffer processing before sputtering.

In combination with the first aspect, furthermore, every one of the sputtering zones has a different target material.

According to the above technical solution, coating with two or more materials can be realized by the coating equipment, which can meet the processing needs of different performance of products.

In combination with the first aspect, furthermore, the coating chamber is connected with an etching chamber, and an inlet of the coating chamber is in connection with an outlet of the etching chamber, the gate valve is arranged between the inlet of the coating chamber and the outlet of the etching chamber, the gate valve is configured to control connecting or disconnecting the inlet of the coating chamber and the outlet of the etching chamber.

According to the above technical solution, processing can be performed in separate zones , namely in the etching chamber and the coating chamber by closing the gate valve. The etching chamber and the coating chamber can be in the same vacuum state by opening the gate valve. When the surface of the workpiece is being processed, the gate valve is closed, in particular, the surface of the workpiece is etched in the etching chamber at first, so that the adhesion performance of the surface of the workpiece is improved. Then the gate valve is opened, and then the gate valve is closed after the etched workpiece enters the coating chamber. In the coating chamber, physical vapor deposition is performed on the surface of the workpiece to form a coating layer that is both non-stick and wear-resistant.

In combination with the first aspect, furthermore, an outlet of the coating chamber and the inlet of the etching chamber are connected through a conveying mechanism so as to form an annular production line.

According to the above technical solution, the transfer mechanism can circulate workpieces between the etching chamber and the coating chamber, and can realize automated processing and transportation in a vacuum state. Through the improvement of the design of coating equipment, processing in separate zones can be realized in the etching chamber and coating chamber, in addition, a continuous transportation of workpieces can be realized through the transfer mechanism, so that the continuous and uninterrupted processing of workpieces is achieved, which reduces the switching time, thereby improving the production efficiency and reducing the processing cost, thereby facilitating the Mass production.

As a second aspect, the application provides a coating method suitable for the coating equipment according to the first aspect, the coating method comprises processing steps under atmospheric pressure and processing steps under vacuum,

the processing steps under atmospheric pressure comprise:

loading and unloading: taking out the workpiece coated in the coating chamber, and placing the workpiece to be processed on a production line;

heating: heating the workpiece to be processed to 150°C to 250°C;

transferring in: transporting the workpiece to be processed after being heated to the entrance to etching process;

transferring out: detecting the workpiece coated, and transferring the workpiece detected in a step of loading and unloading;

the processing steps under vacuum comprise:

vacuum mode: vacuumizing the etching chamber and coating chamber into a vacuum state through the vacuum device;

inputting: closing a transfer valve between the input zone and the etching zone of the etching chamber, breaking vacuum of the input zone, closing the gate valve of the entrance to etching process after the workpiece to be processed enters the input zone through the entrance to etching process, and vacuumizing the input zone into a vacuum state;

etching: opening the transfer valve between the input zone and the etching zone, closing the transfer valve between the input zone and the etching zone after the workpiece enters the etching zone, heating the workpiece; etching the surface of the workpiece with a plasma source after the heating is completed; opening a transfer valve between the etching zone and the waiting zone after the etching is completed, and then closing the transfer valve between the etching zone and the waiting zone after the workpiece enters the waiting zone of the etching chamber;

coating: opening a transfer valve between the etching chamber and the coating chamber, and closing the transfer valve between the etching chamber and the coating chamber after the workpiece etched enters a buffer zone of the coating chamber; opening a transfer valve between the buffer zone and a sputtering zone of the coating chamber, then closing the transfer valve between the buffer zone and the sputtering zone of the coating chamber after the workpiece enters the sputtering zone, and processing the surface of the workpiece in the sputtering zone to form a deposition layer; opening a transfer valve between the sputtering zone and the cooling zone, then closing the transfer valve between the sputtering zone and the cooling zone after the workpiece coated enters the cooling zone; opening a transfer valve between the cooling zone and the output zone after the workpiece is cooled, and then closing the transfer valve between the cooling zone and the output zone after the workpiece enters the output zone;

outputting: breaking vacuum of the output zone, opening the gate valve of the exit of coating process, closing the gate valve of the exit of coating process after the workpiece enters a step of transferring out, and vacuumizing the output zone.

By the above technical solution, the coating production process has been optimized, the production efficiency has been improved, by which an automated production can be realized and the processing cost of a single product can be reduced.

In summary, the present application includes at least one of the following beneficial technical effects:
1. With the coating equipment of the application, the processing time of a single product can be shortened from 3 hours to 5-8 minutes, which improves the production efficiency, greatly reduces the processing cost of a single product, thereby meeting the needs of mass production.
2. With the coating equipment of the application, processing quality is more stable, and the environmental pollution has been reduced.
3. With the coating equipment of the application, the coating processing with two or more materials can be realized, and the switch of the production line is more flexible, so that the coating requirements to achieve the performance of various products can be met without changing the production line.
4. With the coating method of this application, the production process of coating has been optimized, thereby improving the production efficiency and effectively reducing the processing cost.

### BRIEF DESCRIPTION OF THE DRAWINGS

Fig. 1 is a structure diagram of the first embodiment of the coating equipment according to the present application;
Fig. 2 is a schematic diagram of the first embodiment of the coating equipment of the present application with the workpiece being transported to the occupancy detection device by the second rotary transport mechanism;
Fig. 3 is a schematic diagram of the first embodiment of the coating equipment of the present application with the workpiece at the handling mechanism of the coating equipment;
Fig. 4 is a schematic diagram of the first embodiment of the coating equipment of the present application with the workpiece at the heating channel of the coating equipment;
Fig. 5 is a schematic diagram of the first embodiment of the coating equipment of the present application with the workpiece at the first rotary transport mechanism of the coating equipment;
Fig. 6 is a schematic diagram of the first embodiment of the coating equipment of the present application with the workpiece being transported to the entrance to etching process;
Fig. 7 is a schematic diagram of the first embodiment of the coating equipment of the present application with the workpiece entering the input zone of the etching chamber;
Fig. 8 is a schematic diagram of the first embodiment of the coating equipment of the present application with the workpiece entering the heating zone of the etching zone of the etching chamber;
Fig. 9 is a schematic diagram of the first embodiment of the coating equipment of the present application with the workpiece entering the processing zone of the etching zone;
Fig. 10 is a schematic diagram of the first embodiment of the coating equipment of the present application with the workpiece in the vacuuming zone of the coating chamber;
Fig. 11 is a schematic diagram of the first embodiment of the coating equipment of the present application with the workpiece entering the output zone from the coating chamber;
Fig. 12 is a schematic diagram of the first embodiment of the coating equipment of the present application with the workpiece entering the second rotary transport mechanism from the coating chamber;
Fig. 13 is a structure diagram of the coating chamber of the second embodiment of the coating equipment according to the present application;
Fig. 14 is a structure diagram of the coating chamber of the third embodiment of the coating equipment according to the present application;
Fig. 15 is a structure diagram of the coating chamber of the fourth embodiment of the coating equipment according to the present application.

Listing of reference signs:

1. etching chamber; 11. entrance to etching process; 12. input zone; 13. first transfer valve; 14. etching zone; 141. heating zone; 142. processing zone; 143. waiting zone; 2. second transfer valve; 3. coating chamber; 31. vacuuming zone; 32. buffer zone; 33. sputtering zone; 34. cooling zone; 35. third transfer valve; 36. output zone; 37. exit of coating process; 310. first chamber; 311. first buffer zone; 312. first sputtering zone; 313. first cooling zone; 320. fourth transfer valve; 330. second chamber; 331. second buffer zone; 332. second sputtering zone; 333. second cooling zone; 4. first rotary transport mechanism; 5. occupancy detection zone; 6. handling mechanism; 61. unloading mechanism; 62. loading mechanism; 7. conveying mechanism; 8. heating channel; 9. second rotary transport mechanism; 100. workpiece.

### DETAILED DESCRIPTION

For a better understanding of the purpose, technical solutions, and advantages of embodiments of the present application, the present application will be further described below in details in conjunction with the drawings. The assemblies of the embodiments of the present application typically described and shown in the drawings can be arranged and designed in various different configurations. Based on the embodiments in the present application, all other embodiments obtained by ordinary technicians in the art without creative labor fall within the scope of protection of the present application.

It should be noted that similar labels and letters represent similar terms in the drawings, and, once an item is defined in a figure, further definition and explanation are not required in subsequent figures.

In the description of the present application, it should be noted that, unless otherwise specified and limited, the terms "installation", "in connection with", and "connection" should be understood broadly, for example, they can be fixed connection, detachable connection, or integrated connection; or, alternatively, it can be a mechanical connection or an electrical connection; or, alternatively, it can be directly connected, or indirectly connected via an intermediate medium, or it can be internal communication between two components. For those skilled in the art, the specific meanings of the above terms in the present application can be understood in particular circumstances.

In the description of the present application, it should be understood that, the terms "up", "down", "left", "right", etc. indicate the orientation or positional relationship based on the orientation or positional relationship shown in the drawings, only for the convenience of describing the present application and simplifying the description, rather than indicating or implying that a device or component referred to must have a specific orientation, or be constructed and operated in a specific orientation, and therefore should not be understood as a limitation to the present application.

The following will provide a detailed explanation of some embodiments of the present application in conjunction with the drawings. Without conflict, the features in the following embodiments can be combined with each other.

### Embodiment 1

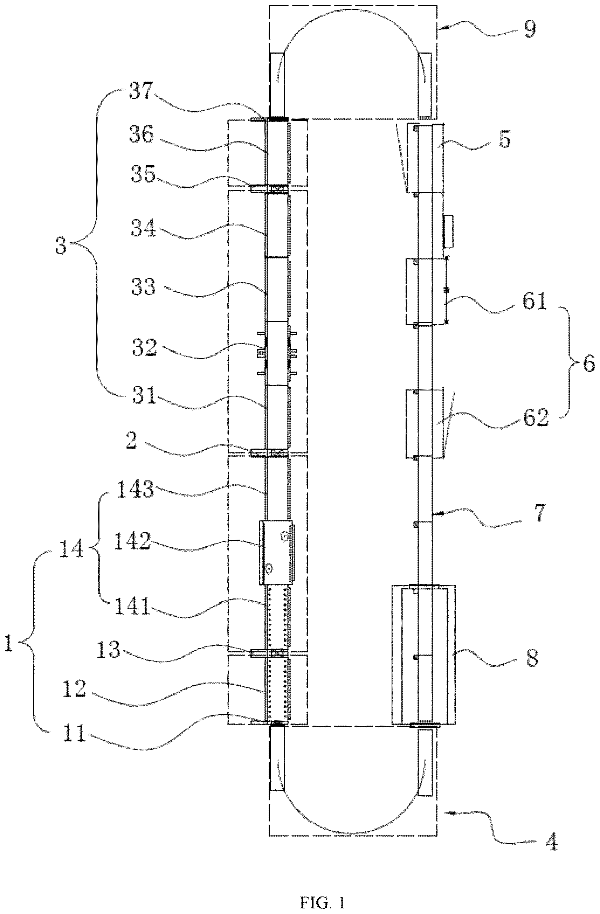

Fig. 1 is a structure diagram of an embodiment of the coating equipment. The coating equipment includes an etching chamber 1, a coating chamber 3, a transfer mechanism (not shown) and a vacuum device. The etching chamber 1 is configured to etch the surface of the workpiece 100 to improve the adhesion performance of the surface of the workpiece 100. The etching chamber 1 includes a plasma source for processing the surface of the workpiece 100, an entrance to etching process 11 and an exit of etching process. The coating chamber 3 is configured to form a deposition layer on the surface of the workpiece 100. The coating chamber 3 includes a sputtering cathode for sputtering the etched surface of the workpiece 100, an entrance to coating process with a transfer valve and an exit of coating process 37 with a gate valve. A second transfer valve 2 is provided between the exit of etching process and the entrance to coating process. The transfer mechanism is at least partially disposed in the etching chamber 1 or the coating chamber 3, and is configured to transport the workpiece 100 processed in the etching chamber 1 to the coating chamber 3. In this embodiment, the vacuum device is in connection with the etching chamber 1 and the coating chamber 3 respectively, so as to form a vacuum state in the etching chamber 1 and the coating chamber 3. The exit of etching process and the entrance to coating process are in sealed connection, so that the etching chamber 1 and the coating chamber 3 are in the same vacuum state in the working state of the coating equipment. Because the etching chamber 1 and the coating chamber 3 are vacuum sealed, the vacuum device can also be connected to the etching chamber 1 or to the coating chamber 3 separately, so that the etching chamber 1 and the coating chamber 3 can achieve the same vacuum state together.

The etching chamber 1 includes an input zone 12 with a heating device and at least one etching zone 14 with a plasma source, which are connected with each other. The first transfer valve 13 is disposed between the input zone 12 and the etching zone 14. The entrance to etching process 11 is arranged in the input zone 12. The spatial volume of the input zone 12 is smaller than the spatial volume of the etching zone 14. The first transfer valve 13 between the etching zone 14 and the input zone 12 is opened after the input zone 12 and the etching zone 14 achieve the same vacuum state. The transfer mechanism transports the workpiece 100 from the input zone 12 to the etching zone 14.

The etching zone 14 includes a heating zone 141, a processing zone 142 and a waiting zone 143 sequentially connected. Transfer valves are respectively arranged between the heating zone 141, the processing zone 142 and the waiting zone 143, so that they can each form a relatively closed space relative to each other. The heating zone 141 is in connection with the input zone 12 and the first transfer valve 13 is disposed between them. The input zone 12 and the heating zone 141 are each provided with a heating device. The workpiece 100 can be heated to a working temperature through the heating device. The plasma source is disposed in the processing zone 142. The second transfer valve 2 is disposed between the waiting zone 143 and the coating chamber 3.

The coating chamber 3 includes a buffer zone 32, a sputtering zone 33, a cooling zone 34 and an output zone 36 which are sequentially connected, a transfer valve is disposed between every two zones, so that the buffer zone 32, the sputtering zone 33, the cooling zone 34 and the output zone 36 can form a relatively closed space relative to each other. The exit of coating process 37 is disposed in the output zone 36. The vacuum device is at least in connection with one of the buffer zone 32, the sputtering zone 33 and the cooling zones 34 to form a vacuum in the buffer zone 32, the sputtering zone 33, and the cooling zone 34. The buffer zone 32 is in connection with the etching zone 14 to park the workpiece 100 transferred from the etching zone 14. The sputtering cathode is disposed in the sputtering zone 33. The cooling zone 34 is provided with a cooling device for cooling the workpiece 100 coated in the sputtering zone 33.

The output zone 36 is also connected to the vacuum device. The transfer valve between the cooling zone 34 and the output zone 36 is opened after the output zone 36 achieves the same vacuum state as the cooling zone 34 be means of the vacuum device. The transfer mechanism transports the workpiece 100 from the cooling zone 34 to the output zone 36. The third transfer valve 35 is disposed between the cooling zone 34 and the output zone. The coating chamber 3 can also be provided with a vacuuming zone 31 in communication with the buffer zone 32, the sputtering zone 33, the cooling zone 34 and the output zone 36. The vacuum device is in connection with the vacuuming zone 31 to vacummize the vacuuming zone 31. The transfer valves between the buffer zone 32, the sputtering zone 33, the cooling zone 34 and the output zone 36 are opened, so that the buffer zone 32, the sputtering zone 33, the cooling zone 34 and the output zone 36 achieve the same vacuum state. The vacuuming device in this embodiment is a vacuum pump.

The entrance to etching process 11 is connected with a first rotary transport mechanism 4. Agate valve is disposed between the entrance to etching process 11 and the first rotary transport mechanism 4. The exit of coating process 37 is connected with a second rotary transport mechanism 9. A gate valve is disposed between the exit of coating process 37 and the second rotary transport mechanism 9. The end of the first rotary transport mechanism 4 facing away from the entrance to etching process 11 is in connection with the end of the second rotary transport mechanism 9 facing away from the exit of coating process 37 through the conveying mechanism 7. The conveying mechanism 7 in this embodiment is a conveyor belt. With the first rotary transport mechanism 4 and the second rotary transport mechanism 9, a 180° rotary transportation can be achieved, so that the coating equipment can operate in endless production mode.

The conveying mechanism 7 is provided with an occupancy detection device, a handling mechanism 6 and a heating channel 8 in sequence in the direction from the second rotary transport mechanism 9 towards the first rotary transport mechanism 4. The handling mechanism 6 includes a loading mechanism 62 and unloading mechanism 61. The occupancy detection device is configured to detect the workpiece 100 on the fixture when the workpiece 100 is transported from the second rotary transport mechanism 9 to the conveying mechanism 7. When it is detected that there is no workpiece 100 on the fixture, the loading mechanism 62 loads the fixture. When it is detected that there is a workpiece 100 on the fixture, the unloading mechanism 61 removes the workpiece 100, after that, the loading mechanism 62 carries out loading. The fixture loaded with workpiece 100 is transported into the heating channel 8 through the conveying mechanism 7. The workpiece 100 is heated in the heating channel 8. The workpiece 100 heated is transported to the input zone 12 through the first rotary transport mechanism 4.

### Embodiment 2

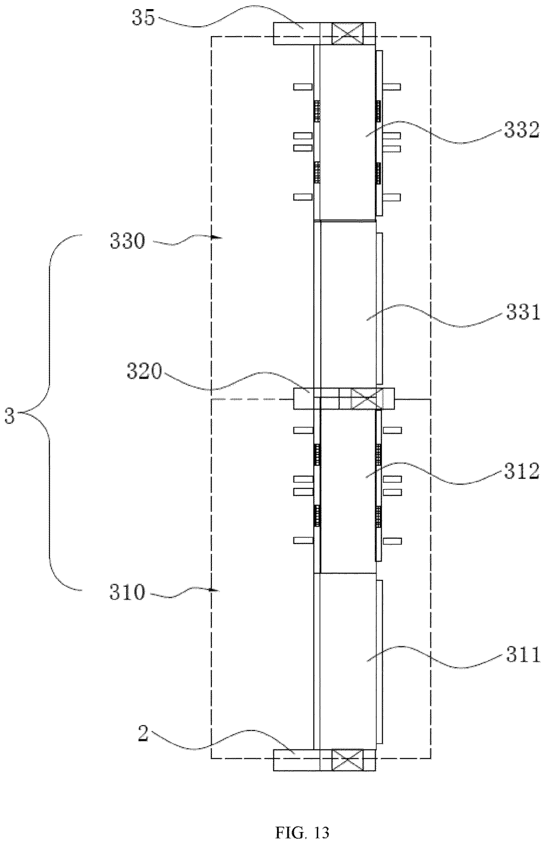

Fig. 13 shows a structure diagram of a second embodiment of the coating equipment. Coating zones are arranged in the coating chamber 3. The difference from Embodiment 1 is that the quantity of the coating chambers 3 is a, a*N coating zones are provided, wherein the a is a natural number from 2 to 4, the N is a natural number from 2 to 4. A fourth transfer valve 320 is disposed between every two coating chambers 3.

Referring to Fig. 13, in the technical solution of this embodiment, there are two coating chambers 3, namely the first chamber 310 and the second chamber 330. The workpiece is coated in the two coating chambers 3. Each coating chamber 3 includes two coating zones, namely a buffer zone and a sputtering zone connected to each other. The first buffer zone 311 of the first chamber 310 is connected to the gate valve 2. The first sputtering zone 312 of the first chamber 310 is in connection with the second buffer zone 331 of the second chamber 330, and a fourth transfer valve 320 is disposed therebetween. A relatively closed space is formed between the first chamber 310 and the second chamber 330 through the fourth transfer valve 320. The second chamber 330 is provided with a third transfer valve 35, such that the coated workpiece is transported out of the second chamber 330 through the third transfer valve 35.

The vacuum device is at least connected to one of the first buffer zone 311, the first sputtering zone 312, the second buffer zone 331 and the second sputtering zone 332, so that the first chamber 310 and the second chamber 330 can be in a vacuum state. The first buffer zone 311 is in connection with the etching chamber 1 to park the workpiece transferred from the etching chamber 1. The sputtering cathode is disposed in the first sputtering zone 312 and the second sputtering zone 332. The target materials in the first sputtering zone 312 and the second sputtering zone 332 are different. After the workpiece is coated with one target material in the first sputtering zone 312, it enters the second sputtering zone 332 to be coated with the second target material, whereby the workpiece can be coated with two materials. If three or four materials are to be coated, an additional coating chamber 3 can be provided. For example, a third chamber and a fourth chamber are provided behind the second chamber 330, and different target materials are adopted in different coating chambers 3.

### Embodiment 3

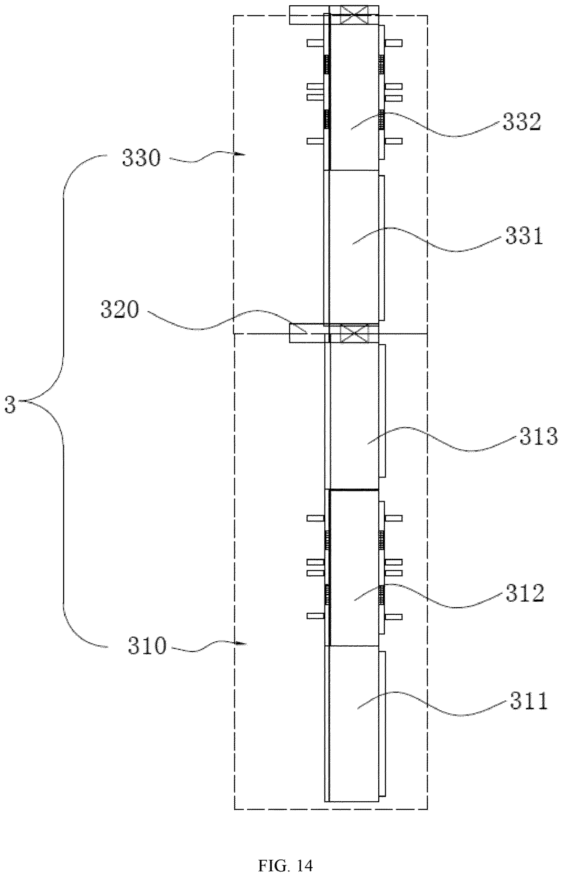

Refer to Fig. 14, the difference from Embodiment 2 is that the first chamber 310 also includes a first cooling zone 313. The first cooling zone 313 is in connection with the first sputtering zone 312 and the second buffer zone 331 respectively. The workpiece processed in the first sputtering zone 312 enters the second buffer zone 331 through the first cooling zone 313. According to the processing requirements, there can be no cooling zone in the first chamber 310, which can be provided in the second chamber 330.

### Embodiment 4

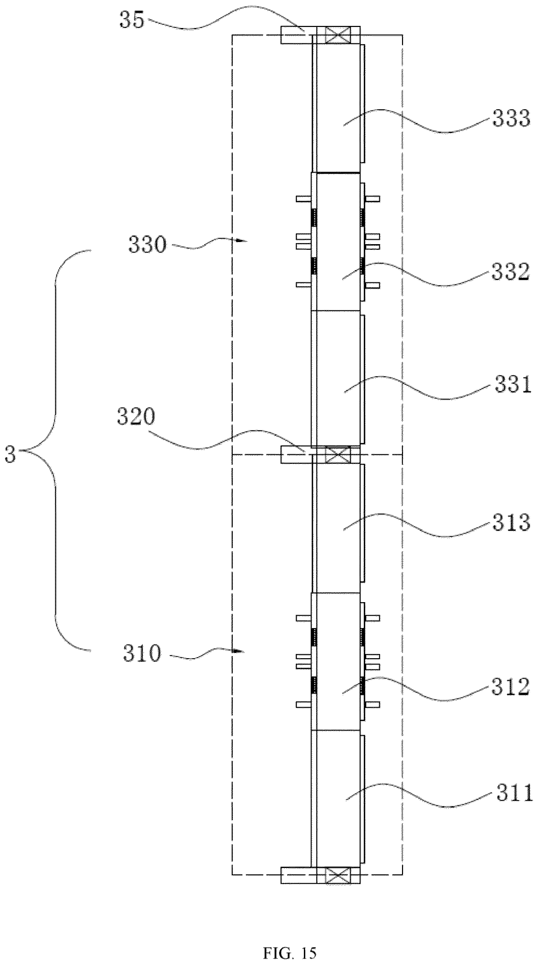

Refer to Fig. 15, the difference between this embodiment and Embodiment 2 is that the first chamber 310 is provided with a first cooling zone 313, and the second chamber 330 is provided with a second cooling zone 333. The first cooling zone 313 is in connection with the first sputtering zone 312 and the second buffer zone 331 respectively. The workpiece processed in the first sputtering zone 312 enters the second buffer zone 331 through the first cooling zone 313. The second cooling zone 333 is in connection with the second sputtering zone 332 and the third transfer valve 35 respectively. The workpiece processed in the second sputtering zone 332 enters the output chamber 35 through the second cooling zone 333.

### Embodiment 5

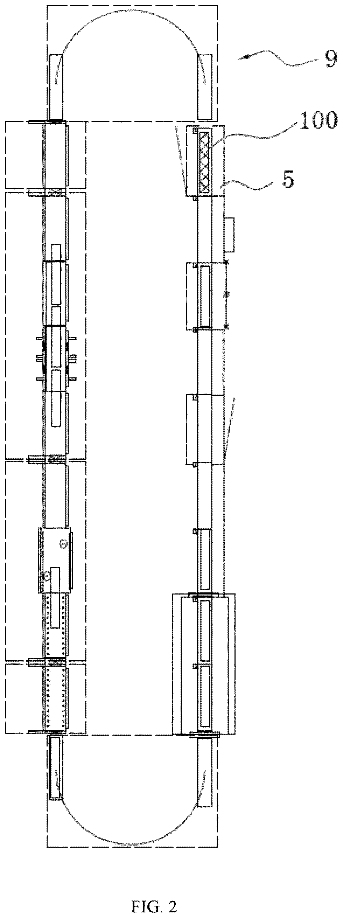

This Embodiment provides a coating method suitable for the coating equipment according to any one of the above Embodiments. The method includes processing steps under atmospheric pressure and processing steps under vacuum:
The processing steps under atmospheric pressure include:
transferring out: referring to Fig. 2, the second rotary transport mechanism 9 transports the coated workpiece 100 to the occupancy detection device to undergo an occupancy detection. The workpiece 100 detected enters a loading and unloading step.

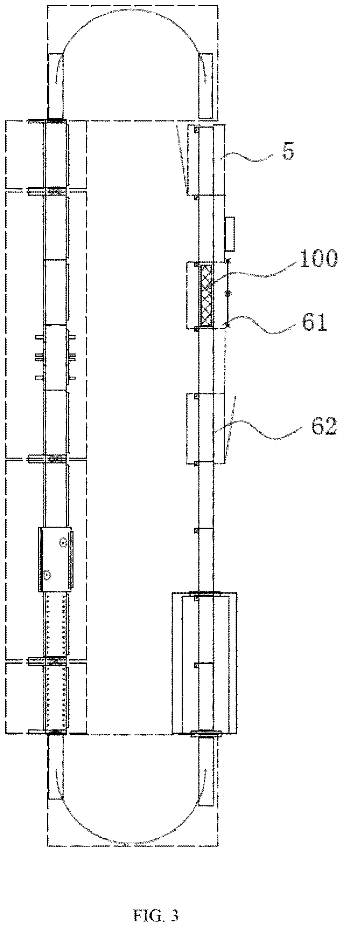

Loading and unloading: referring to Fig. 3, when the occupancy detection device detects that there is no workpiece 100 on the fixture, the loading mechanism 62 loads the fixture; when it is detected that there is a workpiece 100 on the fixture, the loading mechanism 62 carries out loading after the workpiece 100 is removed by the unloading mechanism 61.

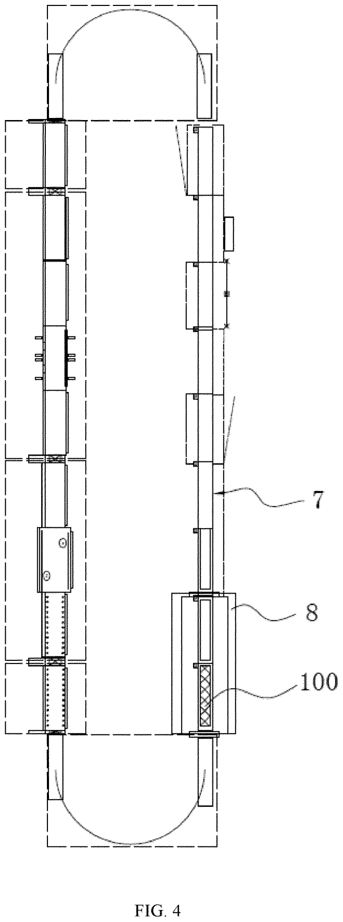

Heating: referring to Fig. 4, the conveying mechanism 7 transports the workpiece 100 to be processed into the heating channel 8, and the workpiece 100 is heated to 150°C to 250°C.

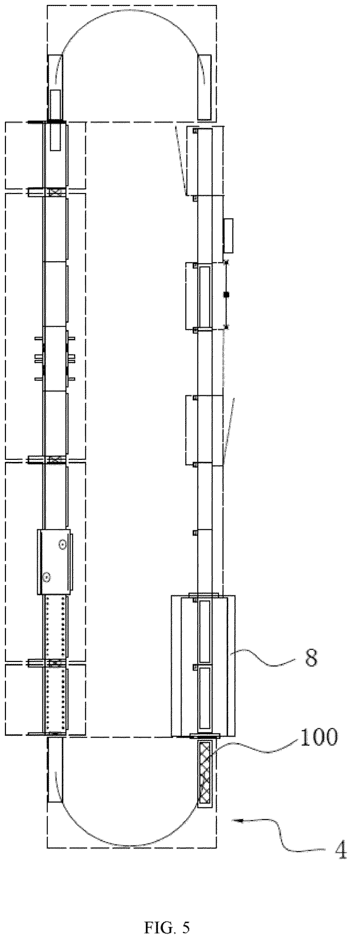

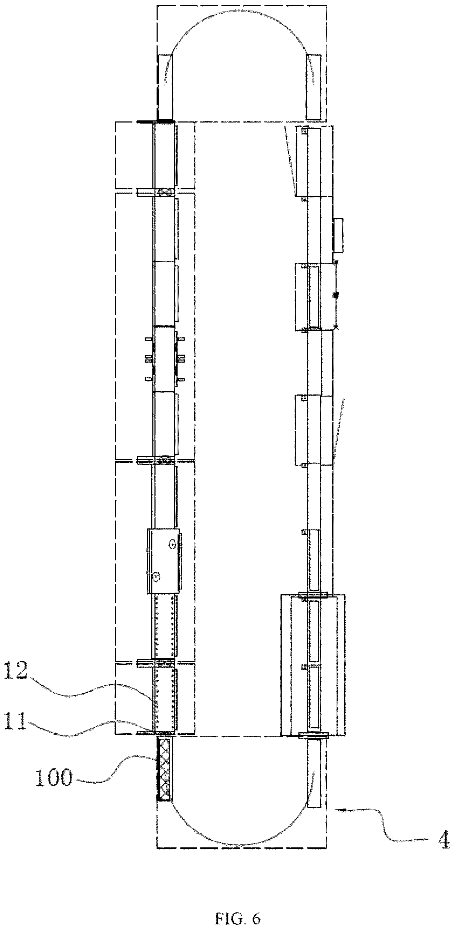

Transferring in: referring to Fig. 5 and Fig. 6, the first rotary transport mechanism 4 transports the workpiece 100 heated to be processed from the heating channel 8 to the entrance to etching process 11, which enters the input zone 12 of the etching chamber 1 after the gate valve of the entrance to etching process 11 is opened.

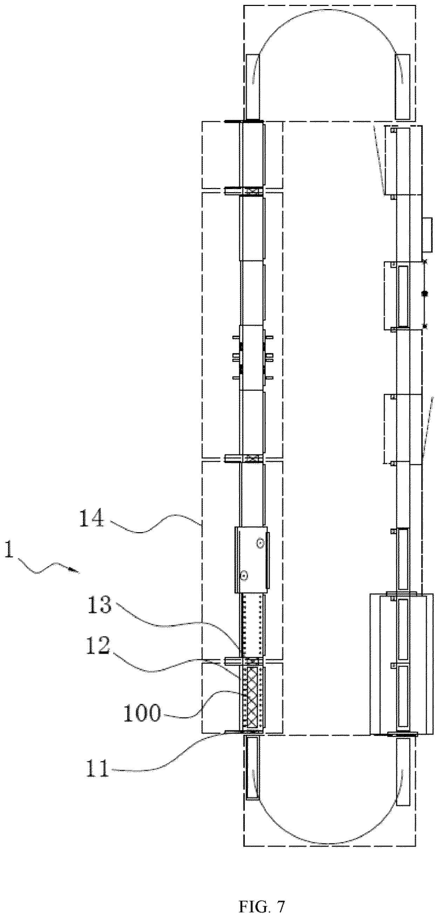

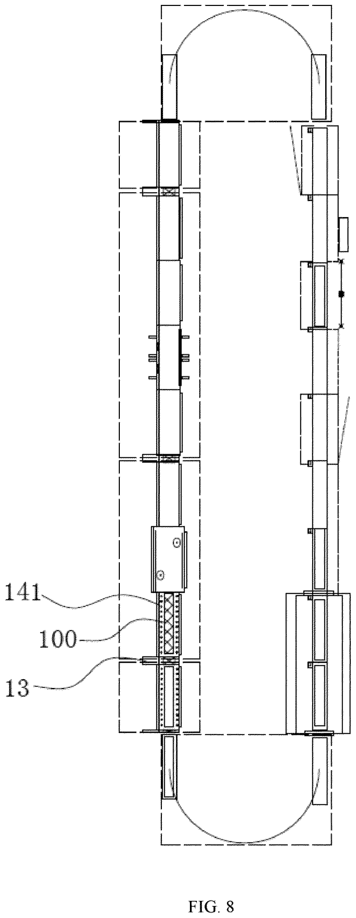

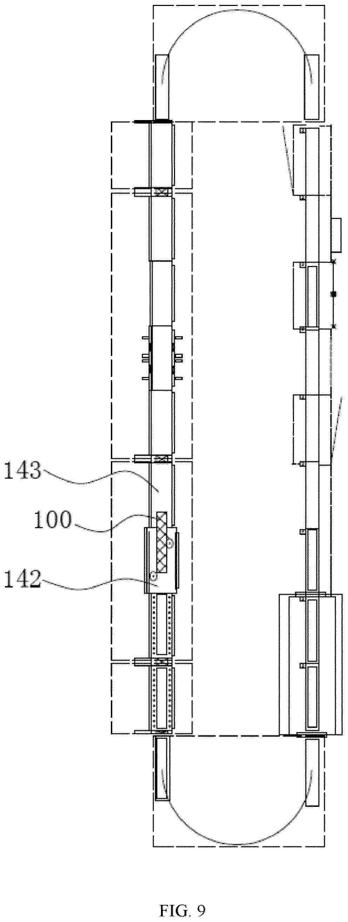

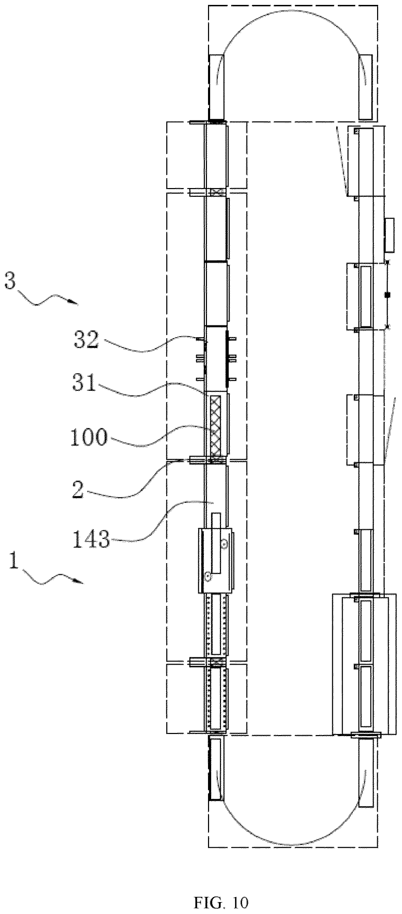

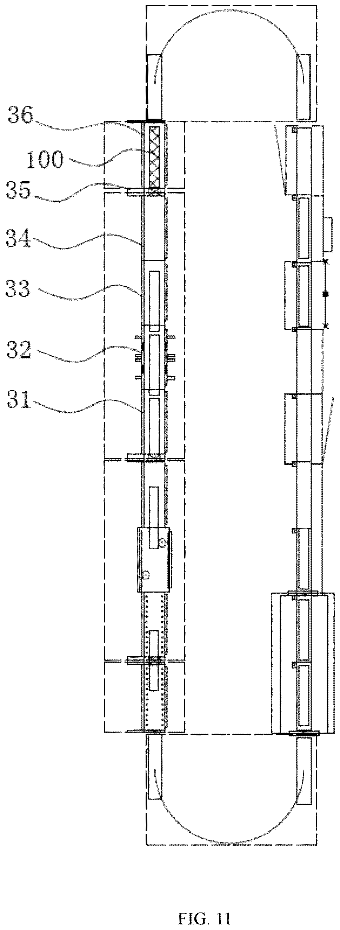

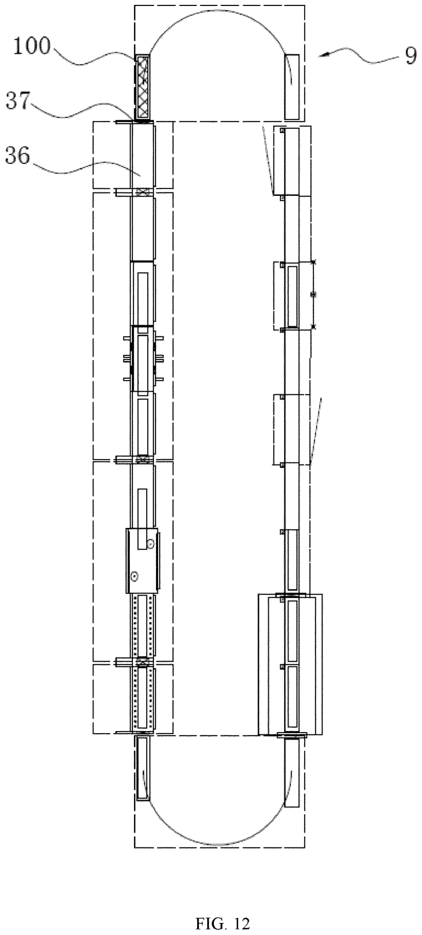

The processing steps under vacuum include:
Vacuum mode: the vacuum device vacuumizes the etching chamber 1 and coating chamber 3, such that they are in a vacuum state.
inputting: referring to Fig. 7, closing the gate valve of the entrance to etching process 11, the first transfer valve 13 between the input zone 12 and the etching zone 14 of the etching chamber 1 is closed, such that vacuum of the input zone 12 is broken, and then the input zone 12 is vacuumized.
heating: referring to Fig. 8, the workpiece 100 enters the heating zone 141 through the first transfer valve 13, then the first transfer valve 13 is closed, and the workpiece 100 is heated.
Etching: refer to Fig. 9, the workpiece 100 enters the processing zone 142 after being heated, the surface of the workpiece 100 is etched with the plasma source; the transfer valve between the processing zone 142 and the waiting zone 143 is opened after the workpiece is etched, such that the workpiece 100 enters the waiting zone 143 of the etching chamber 1, and the transfer valve between the processing zone 142 and the waiting zone 143 is closed.
coating: referring to Fig. 10, the second transfer valve 2 between the etching chamber 1 and the coating chamber 3 is opened, such that the workpiece 100 etched enters the vacuuming zone 31 or buffer zone 32 of the coating chamber 3, and then the second transfer valve 2 between the etching chamber 1 and the coating chamber 3 is closed. Referring to Fig. 11, the transfer valve between the buffer zone 32 and the sputtering zone 33 is opened, such that the workpiece 100 enters the sputtering zone 33, and the transfer valve between the buffer zone 32 and the sputtering zone 33 is closed. The surface of the workpiece 100 is processed in the sputtering zone 33 to form a deposition layer. The transfer valve between the sputtering zone 33 and the cooling zone 34 is opened, such that the workpiece 100 coated enters the cooling zone 34, and then the transfer valve between the sputtering zone 33 and the cooling zone 34 is closed. After the workpiece 100 is cooled, the third transfer valve 35 between the cooling zone 34 and the output zone 36 is opened, such that the workpiece 100 enters the output zone 36, and the third transfer valve 35 between the cooling zone 34 and the output zone 36 is closed.
outputting: referring to Fig. 12, vacuum in the output zone 36 is broken, the gate valve of the exit of coating process 37 is opened, such that the workpiece 100 enters the step of transferring out, the gate valve of the exit of coating process 37 is closed, and the output zone 36 is vacuumized.

The above shows and describes the basic principles, main features, and advantages of the present application. Those skilled in the art should understand that the present application is not limited by the aforementioned embodiments. The aforementioned embodiments and instructions only illustrate the principles of the present application. Without departing from the spirit and scope of the present application, there may be various changes, modifications, substitutions, and variations of the present application, all of which fall within the scope of the claimed protection.

## Claims

1. A coating equipment, **characterized in that** the coating equipment comprises:
an etching chamber (1) configured to improve an adhesion performance of a surface of a workpiece (100), the etching chamber (1) is provided with a plasma source for processing the surface of the workpiece (100), an entrance to etching process (11) with a gate valve and an exit of etching process with a transfer valve;
a coating chamber (3) configured to form a deposition layer on the surface of the workpiece (100), the coating chamber (3) is provided with a sputtering cathode for sputtering the surface of the workpiece (100) etched, an entrance to coating process with a transfer valve and an exit of coating process (37) with a gate valve, the exit of etching process is in connection with the entrance to coating process;
a transfer mechanism at least partially disposed in the etching chamber (1) and/or the coating chamber (3), the transfer mechanism is configured to transport the workpiece (100) processed in the etching chamber (1) to the coating chamber (3);
a vacuum device in connection with the etching chamber (1) and/or the coating chamber (3), the vacuum device is configured to form a vacuum in at least one of the etching chamber (1) and the coating chamber (3);
wherein the exit of etching process is in a sealed connection with the entrance to coating process, so that the etching chamber (1) and the coating chamber (3) are in a same vacuum state in a working state of the coating equipment.

2. The coating equipment according to claim 1, **characterized in that** the etching chamber (1) is provided with an input zone (12) with a heating device and at least one etching zone (14) with a plasma source, the input zone (12) and the etching zone (14) are connected with each other through a transfer valve, the vacuum device is in connection with the etching zone (14) to form a vacuum in the etching zone (14), the entrance to etching process (11) is disposed in the input zone (12), and a spatial volume of the input zone (12) is smaller than a spatial volume of the etching zone (14).

3. The coating equipment according to claim 2, **characterized in that** the input zone (12) is also connected to the vacuum device, after the input zone (12) is in a same vacuum state as the etching zone (14) through the vacuum device, the transfer valve between the etching zone (14) and the input zone (12) is opened, and the transfer mechanism transports the workpiece (100) from the input zone (12) to the etching zone (14).

4. The coating equipment according to claim 3, **characterized in that** the etching zone (14) comprises a heating zone (141), a processing zone (142) and a waiting zone (143) which are connected in sequence, there are transfer valves between the heating zone (141), the processing zone (142) and the waiting zone (143), so that the heating zone, the processing zone and the waiting zone can respectively form a relatively closed space , the heating zone (141) and the input zone (12) is connected through the transfer valve, the heating zone (141) is provided with a heating device, the plasma source is disposed in the processing zone (142), and the waiting zone (143) is in connection with the coating chamber (3).

5. The coating equipment according to any one of claims 1 to 4, **characterized in that** the coating chamber (3) comprises a buffer zone (32), a sputtering zone (33), a cooling zone (34) and an output zone (36) which are connected in sequence, there is a transfer valve between each zone, so that the buffer zone (32), the sputtering zone (33), the cooling zone (34) and the output zone (36) can respectively form a relatively closed space, the exit of coating process (37) is disposed in the output zone (36); the vacuum device is at least in connection with one of the buffer zone (32), the sputtering zone (33) and the cooling zone (34) to form a vacuum in the buffer zone (32), the sputtering zone (33), and the cooling zone (34), respectively.

6. The coating equipment according to claim 5, **characterized in that** the buffer zone (32) is in connection with the etching zone (14) to park the workpiece (100) transferred from the etching zone (14), the sputtering cathode is disposed in the sputtering zone (33), and the cooling zone (34) is provided with a cooling device for cooling the workpiece (100) coated in the sputtering zone (33).

7. The coating equipment according to claim 6, **characterized in that** the output zone (36) is also connected to the vacuum device, after the output zone (36) is in a same vacuum state as the cooling zone (34) through the vacuum device, the transfer valve between the cooling zone (34) and the output zone (36) is opened, and the transfer mechanism transports the workpiece (100) from the cooling zone (34) to the output zone (36).

8. The coating equipment according to claim 1, **characterized in that** the entrance to etching process (11) is connected with a first rotary transport mechanism (4), the exit of coating process (37) is connected with a second rotary transport mechanism (9), an end of the first rotary transport mechanism (4) facing away from the entrance to etching process (11) is in connection with an end of the second rotary transport mechanism (9) facing away from the exit of coating process (37) through the conveying mechanism (7), so that an endless production mode is formed in the coating equipment.

9. The coating equipment according to claim 8, **characterized in that** the conveying mechanism (7) is provided with an occupancy detection device, a handling mechanism (6) and a heating channel (8) in sequence in a direction from the second rotary transport mechanism (9) towards the first rotary transport mechanism (4).

10. The coating equipment according to claim 1, **characterized in that** a coating zone is provided in the coating chamber (3), a quantity of the coating chamber (3) is a, a quantity of the coating zone is a*N, wherein a is a natural number from 2 to 4, and N is a natural number from 2 to 4.

11. The coating equipment according to claim 10, **characterized in that** the a is 2 or 3.

12. The coating equipment according to claim 10, **characterized in that** the N is 2 or 3.

13. The coating equipment according to claim 10, **characterized in that** there is a transfer valve between every two of the coating chambers (3).

14. The coating equipment according to claim 10, **characterized in that** the coating chamber (3) comprises at least two coating zones, namely a buffer zone and a sputtering zone which are connected in sequence, and the buffer zone is in connection with an inlet of the coating chamber (3).

15. The coating equipment according to claim 14, **characterized in that** every one of the sputtering zones has a different target material.

16. The coating equipment according to any one of claims 10 to 15, **characterized in that** the coating chamber (3) is connected with an etching chamber (1), and an inlet of the coating chamber (3) is in connection with an outlet of the etching chamber (1), the gate valve (2) is arranged between the inlet of the coating chamber and the outlet of the etching chamber, the gate valve (2) is configured to control connecting or disconnecting of the inlet of the coating chamber (3) and the outlet of the etching chamber (1).

17. The coating equipment according to claim 16, **characterized in that** an outlet of the coating chamber (3) and the inlet of the etching chamber (1) are connected through a conveying mechanism (7) so as to form an annular production line.

18. A coating method, applicable for the coating equipment according to any one of claims 1 to 9, **characterized in that** the coating method comprises processing steps under atmospheric pressure and processing steps under vacuum,
the processing steps under atmospheric pressure comprise:
loading and unloading: taking out the workpiece (100) coated in the coating chamber (3), and placing the workpiece (100) to be processed on a production line;
heating: heating the workpiece (100) to be processed to 150°C to 250°C;
transferring in: transporting the workpiece (100) to be processed after being heated to the entrance to etching process (11);
transferring out: detecting the workpiece (100) coated, and transferring the workpiece (100) detected in a step of loading and unloading;
the processing steps under vacuum comprise:
vacuum mode: vacuumizing the etching chamber (1) and the coating chamber (3) into a vacuum state through the vacuum device;
inputting: closing a transfer valve between the input zone (12) and the etching zone (14) of the etching chamber (1), breaking vacuum of the input zone (12), closing the gate valve of the entrance to etching process (11) after the workpiece (100) to be processed enters the input zone (12) through the entrance to etching process (11), and vacuumizing the input zone (12) into a vacuum state;
etching: opening the transfer valve between the input zone (12) and the etching zone (14), closing the transfer valve between the input zone (12) and the etching zone (14) after the workpiece (100) enters the etching zone (14), heating the workpiece (100); etching the surface of the workpiece (100) with a plasma source after the heating is completed; opening a transfer valve between the etching zone (14) and a waiting zone (143) after the etching is completed, and then closing the transfer valve between the etching zone (14) and the waiting zone (143) after the workpiece (100) enters the waiting zone (143) of the etching chamber (1);
coating: opening a transfer valve between the etching chamber (1) and the coating chamber (3), and closing the transfer valve between the etching chamber (1) and the coating chamber (3) after the workpiece (100) etched enters a buffer zone (32) of the coating chamber (3); opening a transfer valve between the buffer zone (32) and a sputtering zone (33) of the coating chamber (3), then closing the transfer valve between the buffer zone (32) and the sputtering zone (33) of the coating chamber (3) after the workpiece (100) enters the sputtering zone (33), and processing the surface of the workpiece (100) in the sputtering zone (33) to form a deposition layer; opening a transfer valve between the sputtering zone (33) and the cooling zone (34), then closing the transfer valve between the sputtering zone (33) and the cooling zone (34) after the workpiece (100) coated enters the cooling zone (34); opening a transfer valve between the cooling zone (34) and the output zone (36) after the workpiece (100) is cooled, and then closing the transfer valve between the cooling zone (34) and the output zone (36) after the workpiece (100) enters the output zone (36);
outputting: breaking vacuum of the output zone (36), opening the gate valve of the exit of coating process (37), closing the gate valve of the exit of coating process (37) after the workpiece (100) enters a step of transferring out, and vacuumizing the output zone (36).
